(19) Europäisches Patentamt
European Patent Office
Office européen des brevets

(11) **EP 4 654 139 A1**

(12) **EUROPEAN PATENT APPLICATION**

(43) Date of publication:
**26.11.2025 Bulletin 2025/48**

(21) Application number: **25177749.6**

(22) Date of filing: **20.05.2025**

(51) International Patent Classification (IPC):
**G06T 15/00** (2011.01)     **G06T 15/04** (2011.01)

(52) Cooperative Patent Classification (CPC):
**G06T 15/04; G06T 15/005**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **22.05.2024 GB 202407299**

(71) Applicant: **Imagination Technologies Limited
Kings Langley, Hertfordshire WD4 8LZ (GB)**

(72) Inventors:
• **Spreij, Tijmen
  Hertfordshire, WD4 8LZ (GB)**
• **Younes, Hamoud
  Hertfordshire, WD4 8LZ (GB)**
• **Naylor, Stuart
  Hertfordshire, WD4 8LZ (GB)**

(74) Representative: **Slingsby Partners LLP
1 Kingsway
London WC2B 6AN (GB)**

(54) **VOLUMETRIC POINT FILTERING UNIT AND METHOD**

(57) A filtering unit implemented in hardware logic configured to apply one or more filtering methods to a plurality of input values to determine output values. The filtering unit comprises a plurality of inputs configured to receive one or more input values, one or more signal values, and one or more filter coefficients. The one or more signal values define a filtering mode and wherein each of the one or more filter coefficients corresponds to one of the one or more filtering methods. The filtering unit comprises a computation pipeline configured to receive two input values and a corresponding filter coefficient, and perform an interpolation using at least the two input values and the corresponding filter coefficient.. The filtering unit comprises a plurality of registers configured to store intermediate output values generated by the computation pipeline. The filtering unit is configured to receive one or more signal values, a volumetric filter coefficient, and an input value, and determine i) that a filtering mode defined by the received one or more signal values comprises volumetric filtering and at least one other filtering method and ii) that the volumetric filter coefficient is equal to zero. In response to determining i) and ii) the filtering unit is configured to store the received input value in a register of the plurality of registers.

FIGURE 6

**Description**

CROSS-REFERENCE TO RELATED APPLICATION

This application claims priority from UK patent application GB2407299.3 filed on 22 May 2024, which is herein incorporated by reference in its entirety.

TECHNICAL FIELD

The present disclosure relates to filtering units configured to apply filtering to input values to determine output values, and in particular to efficient ways of processing volumetric point filtering in filtering units.

BACKGROUND

In 3D computer graphics, much of the information contained within a scene is encoded as surface properties of 3D geometry. Texture mapping, which is an efficient technique for encoding this information as bitmaps, is therefore an integral part of the process of rendering an image. However, reading directly from textures usually does not provide satisfactory image quality as the projection of 3D geometry often requires some form of resampling. As a result, as part of rendering a scene, a graphics processing unit (GPU) performs texture filtering.

There are many scenarios in which texture filtering may be performed to improve rendering quality, or to avoid artefacts, and the type of filter differs depending on the scenario. Typically, a texture is stored as an array of texels, where texels in a texture are analogous to the pixels in an image. Generally, it would be unusual for the texels of a texture to align exactly with the pixels of a scene to be rendered. Therefore, general, texture filtering is performed because the pixel centres (in the rendered scene) do not align with the 'texel' centres that encode the texture. For example, in different situations, pixels can be larger or smaller than texels.

Some particular methods for texture filtering include volumetric, anisotropic, and trilinear filtering. Depending on the scene to be rendered, these methods may be applied alone, or in any combination. Since filtering can be a computationally expensive operation requiring many multiplication operations, hardware acceleration is usually used to accelerate the filtering. The hardware used to implement this acceleration can be large and complex, and moreover complicated to schedule, especially when combinations of volumetric, anisotropic, and trilinear filtering is needed. In some cases, due to the need to implement the hardware in a particular way, certain combinations of filtering modes can give rise to undesirable inefficiencies. It would therefore be beneficial to improve the efficiency of acceleration hardware in cases where such combinations of filtering modes are used.

The embodiments described below are provided by way of example only and are not limiting of implementations which solve any or all of the disadvantages of known methods of implementing texture filtering in hardware.

SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

There is provided a filtering unit implemented in hardware logic, the filtering unit configured to apply one or more filtering methods to a plurality of input values to determine output values, the filtering unit comprising:

a plurality of inputs configured to receive: one or more input values, one or more signal values, one or more filter coefficients, wherein the one or more signal values define a filtering mode and wherein each of the one or more filter coefficients corresponds to one of the one or more filtering methods;

a computation pipeline, wherein the computation pipeline is configured to:

receive two input values and a corresponding filter coefficient; and
perform an interpolation using at least the two input values and the corresponding filter coefficient;

a plurality of registers configured to store intermediate output values generated by the computation pipeline;

wherein the filtering unit is configured to:

receive one or more signal values, a volumetric filter coefficient, and an input value;

determine i) that a filtering mode defined by the received one or more signal values comprises volumetric filtering and at least one other filtering method and ii) that the volumetric filter coefficient is equal to zero;

in response to determining i) and ii), store the received input value in a register of the plurality of registers.

The filtering unit is therefore able to bypass the computation pipeline in response to determining i) and ii), instead of using the computation pipeline to compute an interpolation with a coefficient of zero, which would not change the value of the input value. Advantageously, therefore, the computation pipeline is available for scheduling and/or computation of another interpolation during a cycle in which the received input value is stored in the register of the plurality of registers.

In some examples, the input value is a texture value, and the plurality of inputs may comprise: a texture input configured to receive the one or more texture values, a signal input configured to receive the one or more signal values, and a coefficient input configured to receive the one or more filter coefficients. The filtering mode may be defined by a combination of one or more filtering methods. The intermediate output values, which the plurality of registers is configured to store after having been generated by the computation pipeline, in examples represent intermediate filtering results. The computation pipeline may be comprised within a datapath block.

In example implementations, the filtering unit is configured to store the received input value in a register, in response to determining i) and ii), by bypassing the computation pipeline thereby without causing the computation pipeline to perform an interpolation using the received input value.

In example implementations, the filtering unit is configured to determine which register to use to store the received input value in response to identifying which register the computation pipeline would have been configured to use to store a result of an interpolation using the input value and the volumetric filter coefficient.

In example implementations, the volumetric filtering method defined by the received one or more signal values is a volumetric point filtering method.

In example implementations, the computation pipeline is configured to perform a 2-dimensional dot product, and wherein the computation pipeline is configured to perform the interpolation between the two input values, a0 and a1, and the corresponding filter coefficient, c, by calculating $(a0 * (1 - c)) + (a1 * c)$. Thus, in examples, the dot product represented by this calculation is $(a0, a1) \cdot (1 - c, c)$. In example implementations, the input value received by the filtering unit corresponds to a0.

In example implementations, the filtering unit is configured to use the input value, stored in the register, for input into the computation pipeline in a subsequent cycle in combination with a further input value. The further value may be received during the subsequent cycle, and/or the subsequent cycle may be the immediately following cycle.

In example implementations, the filtering unit is configured to receive one or two input values per cycle, and is configured to perform one computation using the computation pipeline per cycle.

In example implementations, the filtering unit comprises a plurality of sequencers, wherein each sequencer is configured, in dependence on one or more received control inputs, to instruct the computation pipeline to perform a computation using two input values.

In example implementations, one sequencer of the plurality of sequencers is configured, during a cycle in which the received input value is stored in the register in response to determining i) and ii), to instruct the computation pipeline to perform a computation using two intermediate output values stored in the plurality of registers. Thus, in some examples, the instructions may cause the computation pipeline to be scheduled to perform the computation. In examples, the scheduled computation may then be performed in a subsequent cycle, e.g., the immediately subsequent cycle.

In example implementations, each sequencer comprises a plurality of hard-coded micro-programs and hardware logic arranged to select one of the micro-programs based on the one or more control inputs, wherein each micro-program defines a sequence of operations to be performed by computation pipeline as part of a filtering operation. In examples, different micro-programs implement different filtering modes defined by different combinations of filtering methods, and the filtering unit may also comprise an arbiter, wherein the arbiter comprises hardware logic arranged to control access to the computation pipeline by the sequencers according to one or more prioritization rules.

In example implementations, the filtering unit comprises a control block, wherein the plurality of sequencers are disposed within the control block, and wherein the control block is configured to output, for each intermediate output value generated by the computation pipeline, a destination for the intermediate output value. The destination may be a register of one of the plurality of registers, and the destination register may be comprised within a subset of registers, also called scratchpad of registers, which are dedicated to one of the plurality of sequencers.

In example implementations, the one or more filtering methods includes anisotropic filtering, trilinear filtering, and volumetric filtering, and wherein the filtering unit is configured to perform any combination of the one or more filtering methods.

In example implementations, the filtering unit is configured to perform any combination of one or more filtering method using the priority order of i) volumetric filtering, ii) anisotropic filtering, and iii) trilinear filtering.

In example implementations, the computation pipeline is further configured to perform an addition between two received input values.

In example implementations, the filtering unit is comprised as part of a graphics processing unit. In some examples, the filtering unit is a texture filtering unit, wherein the one or more filtering methods are one or more texture filtering methods.

There is also provided a method of applying one or more filtering methods to a plurality of input values to determine output values within a filtering unit, wherein the filtering unit comprises a plurality of inputs, a plurality of registers, and a computation pipeline configured to perform an interpolation using at least two input values and a corresponding filter coefficient, the method comprising:

receiving, at the plurality of inputs of the filtering unit:

one or more signal values defining a filtering mode;
a volumetric filter coefficient, corresponding to a volumetric filtering method;
an input value;

determining, at the filtering unit, i) that the filtering mode defined by the one or more signal values comprises volumetric filtering and at least one other filtering method and ii) that the volumetric filter coefficient is equal to zero;
in response to determining i) and ii), storing the received input value in a register of the plurality of registers, wherein the plurality of registers is configured to store intermediate output values generated by the at least one computation pipeline.

In example implementations, the method comprises storing the received input value in the register of the plurality of registers comprises bypassing the computation pipeline and directly storing the received input value in the register without causing the computation pipeline to perform an interpolation using the received input value.

In example implementations, the method further comprises, prior to storing the received input value in a register of the plurality of registers: identifying a register, in the plurality of registers, which the computation pipeline would have been configured to use to store a result of an interpolation using the received input value and the volumetric filter coefficient; wherein the register of the plurality of registers used to store the received input value is the identified register.

There may be provided computer readable code configured to cause any of the methods described herein to be performed when the code is run.

There may be provided an integrated circuit definition dataset that, when processed in an integrated circuit manufacturing system, configures the integrated circuit manufacturing system to manufacture a filtering unit as described herein.

There may be provided a non-transitory computer readable storage medium having stored thereon a computer readable description of a filtering unit as described herein that, when processed in an integrated circuit manufacturing system, causes the integrated circuit manufacturing system to manufacture an integrated circuit embodying the filtering unit.

The filtering unit may be embodied in hardware on an integrated circuit. There may be provided a method of manufacturing, at an integrated circuit manufacturing system, a filtering unit. There may be provided an integrated circuit definition dataset that, when processed in an integrated circuit manufacturing system, configures the system to manufacture a texture filtering unit. There may be provided a non-transitory computer readable storage medium having stored thereon a computer readable description of a filtering unit that, when processed in an integrated circuit manufacturing system, causes the integrated circuit manufacturing system to manufacture an integrated circuit embodying a filtering unit.

There may be provided an integrated circuit manufacturing system comprising: a non-transitory computer readable storage medium having stored thereon a computer readable description of the filtering unit; a layout processing system configured to process the computer readable description so as to generate a circuit layout description of an integrated circuit embodying the filtering unit; and an integrated circuit generation system configured to manufacture the filtering unit according to the circuit layout description.

There may be provided computer program code for performing any of the methods described herein. There may be provided non-transitory computer readable storage medium having stored thereon computer readable instructions that, when executed at a computer system, cause the computer system to perform any of the methods described herein.

The above features may be combined as appropriate, as would be apparent to a skilled person, and may be combined with any of the aspects of the examples described herein.

BRIEF DESCRIPTION OF THE DRAWINGS

Examples will now be described in detail with reference to the accompanying drawings in which:

Figure 1 is a schematic diagram illustrating some rendering logic within a graphics processing unit (GPU);

Figure 2 is a schematic diagram of a first example texture filtering unit;

Figure 3 illustrates an example of volumetric filtering;

Figure 4 shows a graphic representation of the logical pathway for a texture filtering operation that may be implemented by a texture filtering unit as described herein;

Figure 5 is a schematic diagram of a second example texture filtering unit;

Figure 6 is a flowchart showing the operation of a texture filtering unit as described herein;

Figure 7 shows a computer system in which a graphics processing system, including a filtering unit as described herein, is implemented; and

Figure 8 shows an integrated circuit manufacturing system for generating an integrated circuit embodying a filtering unit.

The accompanying drawings illustrate various examples. The skilled person will appreciate that the illustrated element boundaries (e.g., boxes, groups of boxes, or other shapes) in the drawings represent one example of the boundaries. It may be that in some examples, one element may be designed as multiple elements or that multiple elements may be designed as one element. Common reference numerals are used throughout the figures, where appropriate, to indicate similar features.

DETAILED DESCRIPTION

The following description is presented by way of example to enable a person skilled in the art to make and use the invention. The present invention is not limited to the embodiments described herein and various modifications to the disclosed embodiments will be apparent to those skilled in the art.

Texture filtering is implemented in dedicated hardware within a graphics processing unit (GPU). As described above, texture filtering is a computationally expensive operation and so the hardware used to accelerate it can be quite large. In order to increase the throughput and efficiency of the hardware, scheduling logic is used to control the different parts of a filtering operation. However, the scheduling logic or components can be complex, in particular, because they are configured to handle a range combinations of filtering modes.

Described herein is a texture filtering unit that comprises a datapath portion and a control portion which may be implemented within a GPU. In various examples, the datapath portion comprises a plurality of independent computation pipelines that each receive a plurality of inputs and generate an output value as part of a texture filtering operation. In other examples, the datapath portion may comprise a single computation pipeline. The control portion controls access to the computation pipelines and performs dynamic scheduling using a plurality of non-programmable sequencers and an arbiter. The control portion may additionally hand the protocol of transactions of data into and out of the texture filtering unit.

Each filtering operation typically involves multiple computations, and as a consequence requires multiple uses of the same pipeline and/or use of multiple pipelines. Therefore, the output that is generated by a computation pipeline may be an intermediate value that requires further processing (by one of the computation pipelines) or may be the final output of a texture filtering operation. When multiple filtering modes are combined (i.e., two or more operations selected from volumetric, anisotropic, and trilinear filtering mode), the operations for each mode are treated in serial order, i.e., the operations needed to calculate the result of one filter mode are completed before being used as an input for the next filter mode. Thus, when multiple filtering modes are combined, the result of the first filtering mode will be an intermediate value that requires further processing.

Generally, each texture value that is input to the texture filtering unit (and is an input to a texture filtering operation) contributes to a single output (i.e. a single filtered value). However, multiple inputs typically contribute to each output and depending upon whether interleaving is used these inputs may not necessarily be received immediately following each other. The texture filtering unit disclosed herein uses multiple sequencers, each of which oversees/operates the filtering operations for one sequence each. Each sequencer is preferably identical, and each acts as a finite state machine (FSM), with a program counter and some loop variables to keep track of the state. Instructions are registered to instruction registers, and the sequencers can be individually stalled if there is contention for the inputs, or for access to one of the components of the one or more pipelines. Each of the sequencers operates in one of a set of pre-defined and hard-coded operating modes, where the particular mode used at any time is selected dependent upon one or more control inputs. Each of the hard-coded operation modes relates to a different combination of filtering methods and defines a sequence of operations to be performed on a set of input data to generate the final output of the texture filtering operation.

The texture filtering unit contains another component called an arbiter, which is configured to control which sequencer has access to each of the computation pipelines, at any given time, based on predefined rules. This can result in individual sequencers being stalled but the computation pipelines are not stalled. This increases the efficiency of the hardware and increases the throughput without requiring additional pipelines in the datapath (i.e., without requiring dedicated pipelines for each operating mode or for each sequencer). The throughput benefit may be particularly noticeable when switching between operating modes because hand-optimising the transition between sequences in known systems is impractical. The use of sequencers and an arbiter in this way also provides the ability to handle interleaved signals (e.g. for each of the colour changes of an image) and is flexible (e.g. because the utilisation is not reduced significantly if 3 instead of 4 of the colour changes are computed). The ability to support both serial and interleaved modes also reduces the need for FIFO (first in, first out) logic to multiplex or serialise inputs externally to the texture filtering unit.

**Texture Filtering Unit**

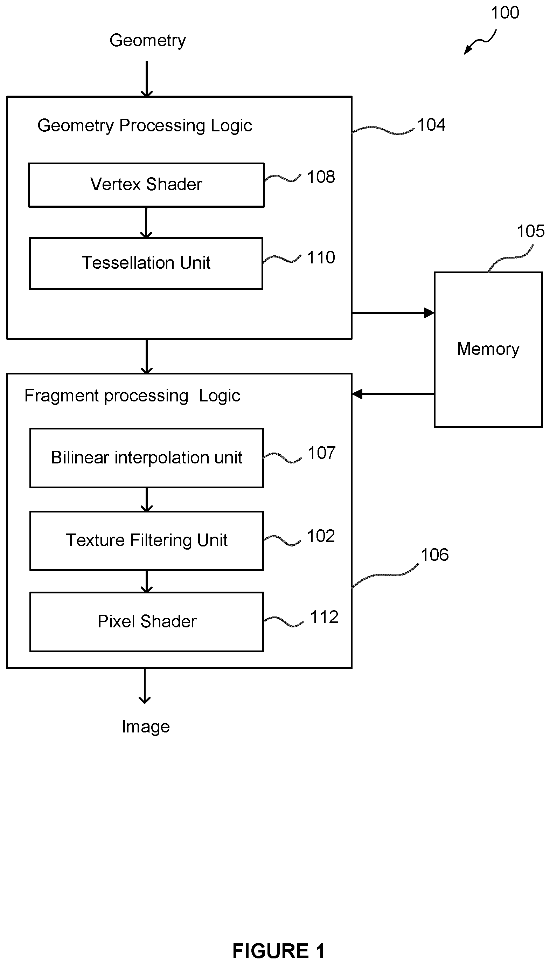

Figure 1 shows a schematic diagram of an example of rendering logic 100 within a graphics processing unit (GPU), and which comprises a texture filtering unit 102. This rendering logic 100 may be implemented in hardware within a GPU. As shown in figure 1, the rendering logic 100 comprises geometry processing logic 104 for performing a geometry processing phase of a rendering process, and fragment processing logic 106 for processing performing a fragment processing / rasterization phase of the rendering process. Data generated by the geometry processing logic 104 may pass directly to the fragment processing logic 106, and/or some of the generated data may be written to memory 105 by the geometry processing logic 104 and then read from memory 105 by the fragment processing logic 106. The geometry processing logic 104 comprises a vertex shader 108 and tessellation unit 110. The geometry processing logic may also comprise a tiling unit (not shown in figure 1). Between the vertex shader 108 and the tessellation unit 110 there may be one or more optional hull shaders (not shown in figure 1). The geometry processing logic 104 may also comprise other elements not shown in figure 1 such as a memory, and other elements.

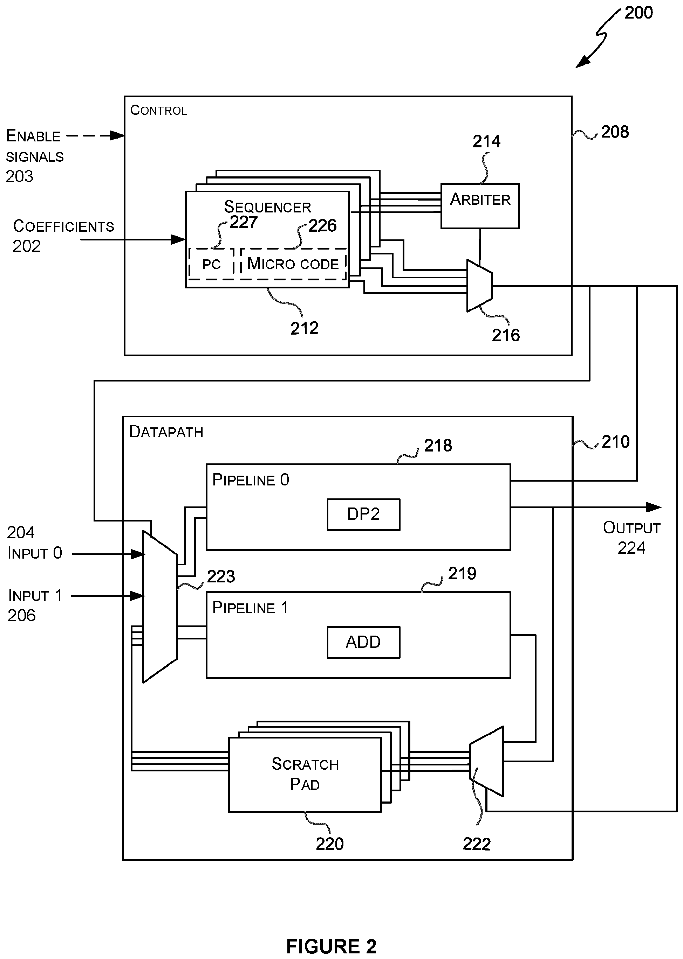

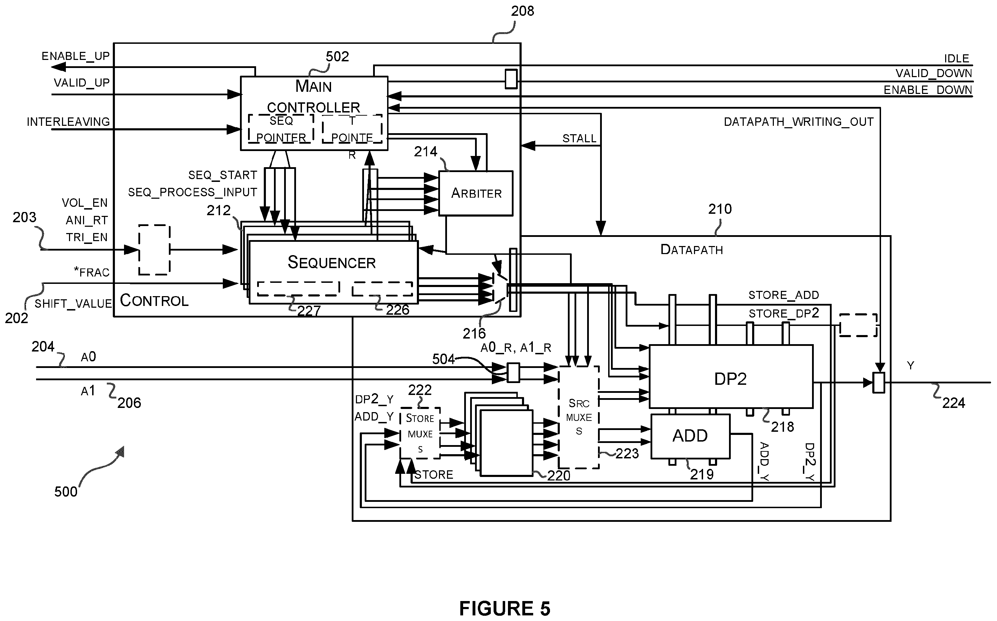

The vertex shader 108 is responsible for performing per-vertex calculations. Unlike the vertex shader, the hardware tessellation unit 110 (and any optional hull shaders) operates per-patch and not per-vertex. The tessellation unit 110 outputs primitives. The fragment processing logic 106 renders some or all of the primitives generated by the geometry processing logic 104. The fragment processing logic 106 comprises a bilinear interpolation unit 107 configured to apply bilinear interpolation to texture values (e.g. texels), a texture filtering unit 102, a pixel shader 112, and may comprise other elements not shown in figure 1. In some implementations, the bilinear interpolation unit 107 and the texture filtering unit may be disposed/comprised within a texture processing unit (TPU). In some other examples, the texture filtering unit 102 may receive texture values (e.g., texels) as input values that have not been processed by the bilinear interpolation unit 107. Furthermore, in some cases, the bilinear interpolation unit may bypass the texture filtering unit 102, e.g., if no further texture filtering operation is needed. Specific examples for the structure and operation of the texture filtering unit 102 are described in greater detail in the examples of figure 2 and 5. Generally, the texture filtering unit 102 may receive up to two input samples per clock cycle, and perform a filtering operation on them as defined by control inputs. The filtering operations can include any combination of volumetric, anisotropic and trilinear filtering operations and in the examples described herein these methods are performed in the order: i) volumetric filtering, ii) anisotropic filtering, then iii) trilinear filtering. This priority order holds for any pairwise combination of filtering methods.

Figure 2 is a schematic diagram of an example texture filtering unit 200, which may form the texture filtering unit 102 in the rendering logic 100 shown in figure 1. The texture filtering unit follows a control-datapath architecture, and as such comprises a control block 208 configured to control, schedule, and oversee filtering operations, and a datapath block 210 configured to receive inputs for filtering and perform the calculations for the filtering operations. As shown in figure 2, the control block 208 of the texture filtering unit 200 is configured to receive a plurality of filter coefficients, and the datapath block 210 is configured to receive two texture value inputs: input0 204 and input1 206. These texture value inputs 204, 206 form at least part of the data that is filtered in the filtering operations performed by the texture filtering unit. The filtering operation to be performed is defined, at least in part, by the enable signals 203.

In various examples, the texture filtering unit 200 may receive one texture value per clock cycle (via either input0 or input1). However, in other examples, a texture filtering unit 200 may be configured to receive two or more texture values per clock cycle (e.g., four texture values per clock cycle) and where more than two texture values are input in a single clock cycle the texture filtering unit 200 may comprise additional inputs for this purpose (not shown in figure 2). The texture values that are received (which may, for example, be the result of bilinear filtering) are usually floating-point values (e.g., full-precision binary floating-point number formats, which may be referred to as F32 values). However, the hardware and methods described herein may be used with texture values of any format (e.g. double-precision or half-precision binary floating-point format, F16, fixed-point format and the like).

The control block 208 comprises a plurality of sequencers 212, an arbiter 214 and a multiplexer 216. In various examples, the control block 208may comprise four identical sequencers 212 as shown in figure 2. In other examples, there may be a different number of sequencers. The datapath block 210 in this example comprises a plurality of parallel, independent pipelines 218-219 and a set of scratchpad registers 220. In one example, there is a set of scratchpad registers for each sequencer 212, i.e., four sets of scratchpad registers, one per sequencer, as in the example shown in figure 2. In various examples, each set of scratchpad registers 220 may comprise a plurality of registers, e.g., 5 or 6 registers. In other examples there may be a different number of registers in each set of scratchpad registers 220. In some examples, the scratchpad registers 220 may be replaced by alternative memory structures that are configured to have similar functionality (e.g. FIFOs or other memories).

The datapath block 210 in this example comprises one or more multiplexers 222-223 that control where intermediate values are stored. In the example of figure 2, one multiplexer 222 (which may be referred to as the store multiplexer) controls where an intermediate value is stored (i.e. in which set of scratchpad registers 220 it is stored) and a second multiplexer 223 (which may be referred to as the source multiplexer) controls what values (which may be input values or intermediate values) are input to each pipeline 218-219. In other examples, the multiplexers 222-223 may be replaced by alternative logic that performs a similar switching and/or selection function. The operation of these multiplexers 222-223 is controlled by the control block 208 in the example shown in figure 2, e.g., as shown by the control lines shown in figure 2 from the arbiter to the multiplexers 222, 223 and pipeline 218.

The role of the arbiter 214 is to determine which sequencer can access which pipelines 218, 219 of the datapath at any given time, i.e., for any given clock cycle. In various examples, the arbiter 214 chooses a sequencer instruction to execute. The store destination of that instruction is thus sent through the pipeline in parallel with the calculation. The arbiter then controls the multiplexing and write-enable of the scratchpad registers. In other examples, the control of the multiplexers 222-223 may be implemented as a separate pipeline, a FIFO, or other state machine. Although figure 2 shows various signal lines, each signal line may represent multiple signals in a practical implementation. Additionally, there may be additional signals not shown in figure 2. Another example of a texture filtering unit is shown in figure 5.

In more detail, the datapath in this example has two pipelines, pipeline0 218 and pipeline1 219. Pipeline0 218 comprises 'DP2' functionality, which is an abbreviation for 2-dimensional dot product (also called 'dimension 2 dot product'). The DP2 logic performs a dot product between two 2-dimensional vectors, as $(a, b) \cdot (c, d) = (a * c) + (b * d)$. In practice, this corresponds to multiplying two input values (a and b) with two coefficients (c and d). In some example hardware implementations, the DP2 is configured to multiply two single precision floating-point values (a and b), e.g., F32 values, with two fixed-point format fractional coefficients (c and d). This dot product functionality can also be used to implement an interpolation between two floating-point values by calculating $a * (1 - c) + b * c$ (in other words, interpolating between scalar values a and b with weighting c). The DP2 logic can also implement and a simple addition, $a + b$, i.e., by setting $c = d = 1$. Collectively, these three functions (dot product, interpolation, and addition) can be combined to perform each of the three texture filtering operations, volumetric, anisotropic, and trilinear filtering, and any combination of these filtering operations. Pipeline1 simply performs an addition between two input values. However, as explained, the DP2 logic can implement an addition itself, and so the logic of the datapath block 210 may be simplified in some examples by removing pipeline1 219 altogether (thus advantageously reducing the overall area of the datapath block in the hardware of the texture filtering unit 200).

As mentioned, the texture filtering unit 200 takes a plurality of texture values as input (via inputs 204, 206) and generates a single filtered output (which is output via output 224) in the datapath block 210, under the control of the control block 208. The filtering is implemented by computational logic blocks within the pipelines 218-219, explained above. Generally, these computational logic blocks may be addition units, multipliers, two-dimensional dot product units (DP2s), three-input additions, fused multiply-adds (FMA) and the like. In the example shown in figure 2, the first pipeline, pipeline0 218, comprises a single DP2 and the second pipeline, pipeline1 219, comprises a single addition unit. In other examples, the pipelines may comprise additional and/or different computational logic blocks (e.g. the first pipeline 218 may comprise a multiplier instead of a DP2, and/or either pipeline may comprise a second or further computational logic block).

A single texture filtering operation may require several passes through one or both of the pipelines 218-219 (as described in more detail below) and intermediate results (i.e., results output by a pipeline which are not final filtered output values) are stored in the scratchpad registers 220 for the corresponding sequencer (i.e. the sequencer that was controlling the pipeline when the intermediate result was generated). These intermediate results can then be read from the scratchpad registers 220 to one of the pipelines 218-219 and used as an input to a subsequent pass through a pipeline. For example, the result of a volumetric filtering operation can be stored in a scratchpad register 220, and subsequently used as an input for an anisotropic filtering operation in one of the pipelines.

In various examples, a final filtered output value may also be stored in the scratchpad registers 220. This can occur in cases where a final filtered value would otherwise reach the output before other sequences, which started earlier, produce a final output. In more detail, this "skipping the queue" happens when a new single cycle sequence arrives whilst at least one previous multicycle sequence is still running and has not yet produced a final output. This is because, in single-cycle operations, the first cycle is also the output cycle. Thus, because the filtering unit is configured to produce outputs in order, the filter unit works around these single-cycle sequences that would otherwise cause out-of-order outputs this by sending the single-cycle result back to the scratchpad registers until it is that sequence's turn to produce an output. Such stored final filtered output values may then be passed back through a pipeline when they can be output, though this may use a cycle of computational logic block (e.g. the DP2).

In various examples the texture filtering unit 200 is arranged to perform any combination of volumetric, anisotropic and trilinear filtering using the DP2 pipeline 218, and the 'ADD' pipeline 219 (or, in alternative examples, just using the DP2 pipeline, which is also capable of performing additions, thus obviating the need for the ADD unit). However, in other examples, the texture filtering unit 200 is arranged to perform any combination of a different set of two or more filtering methods, and may perform any kind of linear filtering, and in some examples also bilinear filtering. The coefficients 202 that are input to the texture filtering unit 200 therefore comprise at least one coefficient for each filtering method that the texture filtering unit 200 can implement. These coefficients are referred to as vfrac, afrac and tfrac (referred to collectively as *frac), in which:

- vfrac is the coefficient for volumetric filtering;

- afrac is the coefficient for anisotropic filtering;

- and tfrac is the coefficient for trilinear filtering.

In various examples, the values of the coefficients may change every clock cycle or may change less frequently or may be constant (e.g. vfrac may change each clock cycle, afrac may change less often and tfrac may be constant). In scenarios where only a proper subset of the filtering methods are used, the coefficients of those methods not being used may be set to a default value (e.g. where anisotropic filtering is not used the coefficient, afrac, may be set to one). Alternatively, separate enable signals 203 may be provided to indicate which of the modes are active.

In examples where enable signals 203 are provided, these provide a value that specifies whether each filtering method (or mode) is enabled. For example, the flags Vol_en, Ani_rt, and Tri_en may be used (as described in figure 5) to indicate which filtering modes to use. Other parameters for the filtering method can also be specified by these values (e.g., the type of anisotropic filtering mode, of which there are several). For example, three enable signals may be provided as detailed below, although certain combinations (e.g. {0,0,0}) may not be permitted or may have special meaning (e.g. resulting in bypassing inputs to the output):

| Enable signal | Possible values | Meaning |
|---|---|---|
| Vol_en | 0, 1 | Volumetric filtering is disabled or enabled, respectively |
| Tri_en | 0, 1 | Trilinear filtering is disabled or enabled, respectively |
| Ani_rt | 0, 1, 3, 5, 7, 9, 11, 13, 15 | Anisotropic filtering is disabled (ani_rt=0), or enabled (ani_rt>0).<br>If ani_rt>0, the number of texture values to be combined is given by one more than the value of the enable signal, i.e., number of texture values to combine = ani_rt + 1 |

The texture filtering unit 200 is arranged to perform filtering using any combination of one or more of a set of filtering methods and as described above. This may involve computations using multiple input texture values and multiple passes through one or both of the pipelines 218, 219. Each pass through a pipeline may use different input values, where the input values may be input texture values or intermediate values calculated in a previous pass through one of the pipelines.

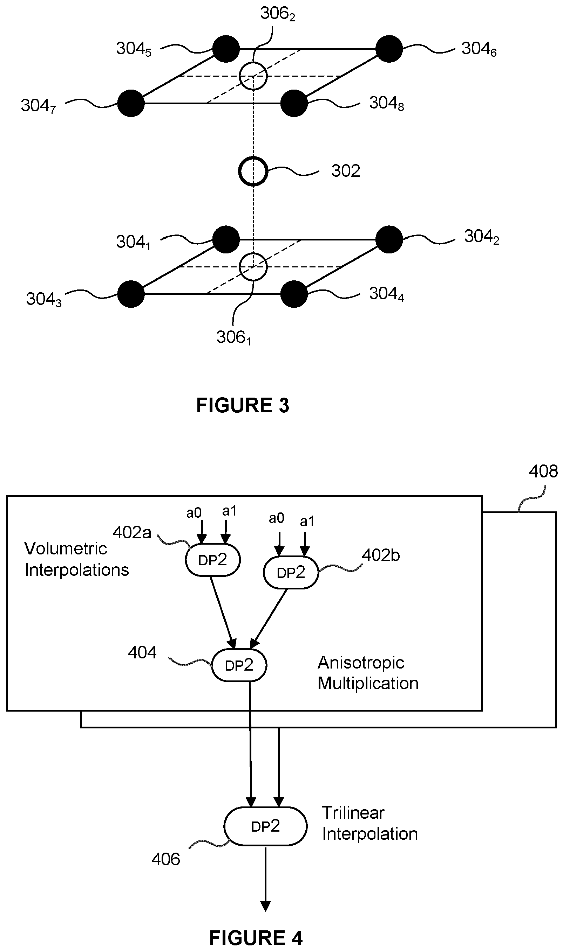

Figure 3 illustrates an example of volumetric filtering for filtering texels of a 3D texture. A texture value is to be sampled at a position 302 within the 3D texture. The fragment processing logic 106 fetches the eight texels $204_1$ to $204_8$ of the texture that are closest to the sample position 302. The eight fetched texels 304 form a cube around the sample position 302 as shown in figure 3. In particular, the eight texels form two planes on opposing sides of the sample position 302. As shown in figure 3, texels $304_1$ to $304_4$ form a first plane below the sample position 302, and texels $304_5$ to $304_8$ form a second plane above the sample position 302. The bilinear interpolation unit 107 performs bilinear interpolation to determine interpolated values at the positions $306_1$ and $306_2$ within each of the planes. In particular, the bilinear interpolation unit 107 determines an interpolated value at the position $306_1$ in the first plane by performing bilinear interpolation on the texels $304_1$ to $304_4$ which form the first plane; and the bilinear interpolation unit 107 determines an interpolated value at the position $306_2$ in the second plane by performing bilinear interpolation on the texels $304_5$ to $304_8$ which form the second plane. The interpolated values at positions $306_1$ and $306_2$ are provided as input values to the texture filtering unit 102. The texture filtering unit thus 102 performs an interpolation (referred to herein as a volumetric filtering operation) to determine an output value representing a texture value at the sample position 302.

Figure 4 shows a graphical representation of the operations performed when the texture filtering unit combines volumetric filtering (as shown in figure 3), with anisotropic filtering (where ani_rt=1, i.e., there are two texture values to combine) and trilinear interpolation. In this example, volumetric interpolations are performed first by two successive operations 402a, 402b using the DP2 of pipeline1 218. The two downward arrows on each of the volumetric interpolations 402a, 402b indicate the two input values, a0 and a1, to be interpolated by the DP2 as part of the volumetric filtering. The two inputs, a, and a1, represent output values $306_1$ and $306_2$ generated by the bilinear interpolation unit. Each respective interpolation 402a, 402b performed by the DP2 is then used as an input for the anisotropic operation. The DP2 is then used again for the anisotropic multiplication 404 (i.e. a third pass through the first pipeline 218). This corresponds to summing the two values produced by the volumetric interpolations 402a, 402b, both multiplied by the same coefficient (afrac). Thus, the anisotropic filtering uses the dot product functionality of the DP2 to multiply two values by a coefficient, and sum them together.

If trilinear filtering is also used (i.e., such that where vol_en=1, tri_en=1 and ani_rt=1) then the DP2 is used again for the trilinear interpolation (block 406). It should be appreciated, however, that the process described in the preceding paragraph will be repeated before the trilinear interpolation is carried out, as indicated by the second box 408 in figure 4, indicating a separate set of volumetric filtering and anisotropic filtering operations. This is because the trilinear interpolation involves two inputs originating from different texture MIPMAPs. Thus, the results of volumetric filtering and subsequent anisotropic filtering are calculated for two MIPMAPs, and combined in the final trilinear interpolation at block 406. The total number of inputs is given by

$$Number\ of\ texture\ values = (vol\_en + 1) * (ani\_rt + 1) * (tri\_en + 1)$$

Thus, if only volumetric filtering and anisotropic-2 filtering are used, there would only be four inputs (2*2*1=4). If trilinear filtering is also used (as in the example of figure 4), there will be 8 inputs (2*2*2=8). In this example, it can be seen that the second pipeline 219 dedicated to additions is not used at all. Where there are two inputs per input transaction, the number of transactions is given by the number of inputs divided by two.

The sequence in which input values and/or intermediate values are input to each of the pipelines (e.g. to implement the texture filtering operations shown in figure 4) is controlled by the control block 208. As described above, each sequencer 212 operates in one of a set of pre-defined and hard-coded operating modes, where the selected mode defines the filtering operation that is applied to a stream of input texture values or on multiple interleaved streams of input texture values. Selection of a mode of operation by a sequencer is dependent upon the enable signals 203 (which may be referred to as control inputs or mode inputs). Each of the hard-coded operation modes is defined in a micro-program (or micro-code) 226 which is synthesised into hardware and comprises a state machine that runs on a stored function, a program counter 227, and in various programs a loop counter (e.g. where the same micro-program 226 is shared between multiple modes and the loops are not flattened so the program counter will be jumping backwards when looping). The micro-program defines a sequence of operations to be performed on a set of input data to generate the final output of the texture filtering operation. Any jumps in a micro-program are dependent only upon the control inputs and not upon the texture values themselves.

However, there may be some exceptions to this. For example, there may be a number of pre-defined input texture values that halt the calculating sequence and trigger the output of the input texture value. In various examples, the mode input that controls jumps in a program may be one of the enable signals 203, Ani_rt (i.e. the anisotropic ratio, as described above). Different micro-programs may therefore be provided to implement each possible filtering operation (one of which is shown in figure 4). Thus, in various examples each scheduler may be identical, i.e., it may comprise the same set of micro-programs, and, in some examples, there may be 5 or 7 micro-programs (and hence modes of operation), where each relates to a different combination of filtering methods.

The use of micro-programs reduces the complexity of the behaviour of the sequencers 212 (e.g. compared to attempting to optimise sequences for all interleaving modes and having transitions between modes handled smoothly) and hence reduces the size (e.g. in terms of area of hardware logic) of the sequencers. By enabling jumps within a micro-program based on control inputs, the number of micro-programs within each sequencer is reduced and hence the area of each sequencer is reduced. Although all the sequencers are described above as being identical, in other examples, the size of the sequencers may be further reduced by having different subsets of micro-programs within different sequencers.

In figure 2, the control block 208 comprises a plurality of sequencers 212 (e.g. four sequencers) and the sequencers 212 have overlapping activity, i.e. more than one sequencer 212 may require the use of the same pipeline at the same time (e.g. two or more sequencers may be operating the same filtering mode and thus both need to use the DP2 in pipeline0 218). The sequencers 212 therefore indicate their status (e.g. in the form of requests for access to resources, where these resources include the pipelines 218-219 and may also include the output 224) to the arbiter 214. The arbiter 214 grants access to computing resources (i.e., the pipelines 218-219) according to a priority scheme (preferably a fixed priority scheme, based on pre-defined rules). In various examples, the arbiter 214 prioritises requests for resources that involve a new input texture value (e.g. input0 204 or input1 206) and otherwise the arbiter 214 implements a fixed prioritization between sequencers 212 (e.g. a round robin arbitration scheme, or other prioritization scheme). As shown in figure 2, the arbiter 214 controls access to the resources in the datapath by controlling a multiplexer 216 within the control block 208. The output from the multiplexer 216 comprises control signals that control the operation of the source multiplexer 223 in the datapath 210 and hence control what values are input to each of the pipelines 218, 219 in any clock cycle. In some examples, multiple control signals are output from the multiplexer 216 to independently control the inputs to each of the pipelines 218-219.

Figure 5 is a schematic diagram of a second example texture filtering unit 500, which may form the texture filtering unit 102 in the rendering logic 100 of figure 1. This texture filtering unit 500 comprises all the elements shown in the texture filtering unit 200 of figure 2, and in addition shows additional signal flows (i.e., signals that enable the sequencers to indicate that they want an input and that said input is the last, when they are idle, stall signals, etc.) and register stages (many of which may also be present in the first example texture filtering unit 200 but are omitted from figure 2 merely for illustrative clarity) and further comprises a main controller unit 502. In this example, the main controller 502 indicates when any of the sequencers 212 can start processing a filtering sequence (i.e., start a new texture filtering operation by executing a micro-program) and which sequence the next input belongs to. Additionally, the main controller unit 502 keeps track of the order in which sequencers are supposed to produce an output and hence ensures that outputs are generated from the texture filtering unit 500 in the right order.

In the examples shown in figures 2 and 5 the datapath 210 comprises only a single DP2 and a single addition unit. In other examples, the datapath 210 may comprise a different combination of computational logic blocks, or may not comprise an 'ADD' pipeline 219 at all (since the DP2 is also configured to perform addition operations). In many examples, the resources within the datapath (i.e. the computational logic blocks within the datapath) are limited, i.e., the total throughput of the computational logic blocks within the pipelines is lower than what the sequencers may request.

As described above, a sequencer may operate on an input stream of texture values or on interleaved streams of texture values. Where interleaving is used, the inputs that contribute to a single filtered output may not be received immediately following each other. The use of interleaved streams may be signalled to the texture filtering unit 102, 200, 500 using an additional enable (or control) signal 203:

| Enable signal | Possible values | Meaning |
|---|---|---|
| Interleaving | 0, >0 | Interleaving is disabled when = 0, or enabled when >0 For an interleaving value > 0, the value of "Interleaving+1" represents the number of sequences that have their inputs interleaved (in other words, the number of sequences in a set). |

The value of "interleaving" thus equals the number of sequences in a set minus 1. The interleaving of input streams of texture values may be used where a plurality of texture values are accessed from memory at the same time (e.g. R and G values) but need to be filtered separately (e.g. where colour filtering is being performed separately for each colour). This improves efficiency since the texture values for the different streams (e.g. RGBA) may be stored contiguously. Advantageously, using interleaving avoids having to deserialize the texture values (which is expensive for long sequences).

**Efficient 3D Point Filtering**

In the examples described above, the texture filtering units 102, 200, 500 are arranged to implement any one or more of: volumetric filtering, anisotropic filtering, and trilinear filtering. In further examples, the texture filtering unit may be arranged to implement any combination of volumetric, anisotropic, trilinear and bilinear filtering (e.g. by changing the micro-programs).

The operation of volumetric filtering comprises interpolating between a cubic arrangement of eight texels depending on a sample point within the cube, as shown in figure 3. Usually, the results of two bilinear interpolations, $306_2$ and $306_1$, are used as inputs for a final interpolation, produces the final result of the volumetric filter operation. Thus, in present examples of volumetric filtering, only the final interpolation is performed by the texture filtering unit 102. When performing volumetric filtering, the texture filtering unit 102 is therefore configured to receive two input values, where each value corresponds to one of the bilinear interpolation results, and one coefficient.

However, a variant of volumetric filtering is called 3D point filtering, or volumetric point filtering. This comprises simply selecting the nearest texture value (e.g., texel) to a sample. In other words, referring to figure 3, this corresponds to selecting the texel value (from $304_{1-8}$) within the cubic arrangement simply by selecting the nearest texel to the sample position. In this case, the bilinear interpolations do not perform an interpolation, though the bilinear interpolation unit 107 may still be used to output the selected nearest sample position. When the only filtering mode used is volumetric point filtering, the texture filter unit 102 may be bypassed entirely, as it is not needed to perform any calculation. Specifically, if the only filter mode engaged is 3D point filtering, i.e., no anisotropic or trilinear filtering is needed, the result of the 3D point filtering may be outputted directly, bypassing the scratchpad registers and bypassing the texture filtering unit 102. Thus, the result is outputted at output 224 shown in figures 2 and 5.

The texture filtering unit typically performs volumetric filtering first when used in combination with anisotropic filtering and/or trilinear filtering, as shown in figure 4, in accordance with the priority regime mentioned above. Thus, in known configurations of texture filtering units, if volumetric filtering of any type (i.e., point or non-point volumetric filtering) is used with anisotropic filtering and/or trilinear filtering, the result of the volumetric filtering needs to be treated as an intermediate value and, and so is usually stored in a scratchpad register 220. However, when another filtering mode is enabled, known texture filtering units are not configured to be bypassed, and so are forced to receive the sample values from the bilinear filters. In other words, the bilinear interpolation unit 107 cannot directly pass the selected sample position to the output since more intermediate values need to be calculated. The bilinear interpolation unit 107 must therefore output their bypassed samples to the texture filtering unit as if the texture filtering unit were about to perform a volumetric filtering interpolation.

Thus, in known implementations, when 3D point filtering is used with another filtering mode, the texture filter unit receives a first bypassed texel value, a0, from a bilinear filter in a first clock cycle, and receives the second bypassed texel value, a1, from a bilinear filter in the same clock cycle. This is because, in implementations, the bilinear interpolation unit comprises two bilinear filters configured to operate in parallel (thus, one bilinear filter provides a0, and the other bilinear filter provides a1 in the same clock cycle). The first value received, a0, is the selected sample value that would otherwise be passed directly to the output (as described above) if other filtering modes were not being used. Since only the first bypassed texel value, a0, is needed, the second texture value (a1) can be set to a generic or arbitrary value in the texture filtering unit. However, the DP2 of the texture filtering unit is configured only to perform dot products, and so in order to obtain the bypassed sample value a0, the coefficient, c, is set to zero. Consequently, the DP2 pipeline is configured to perform the following interpolation operation on a texel value when 3D point filtering is used in combination with another filtering mode:

$$(a0 * (1 - c)) + (a1 * c)$$

which is equal to

$$(a0 * (1 - 0)) + (a1 * 0) = a0$$

The result, a0, can then be stored in the scratchpad register for use with the following filtering mode, i.e., anisotropic filtering.

Internally, in known implementations, the DP2 of the texture filtering unit still performs an interpolation in its datapath as if it were receiving two samples with an interpolation coefficient of 0. This means the datapath of the DP2 isn't available for use by other sequencers in this cycle, even though the DP2 is not being used to calculate an actual interpolation. Moreover, progressing the sample selected in the 3D point filtering, a0, to the storage of the scratchpad register wastes many cycles in this example, since both of the sample values (a0, a1) must be obtained, and the DP2 performs an unnecessary interpolation computation. In typical workloads, the time spent by the texture filtering unit on volumetric point filtering operations is non-negligible. Consequently, in known units, a significant proportion of processing time is wasted when 3D point filtering modes are used in combination with anisotropic filtering and/or trilinear filtering. It would therefore be advantageous if the control and signalling of the texture filtering unit were modified to remove these inefficiencies.

Generally, the problem can be solved by directly registering the input of the first cycle (i.e., a0 received from a bilinear filter) to a scratchpad without the need to send the a0 value via the DP2 pipeline. However, as mentioned above, the scenario in which inefficiencies arise is when the volumetric point filtering is combined with one or both of anisotropic filtering and trilinear filtering. This is because, currently, known texture filtering units of the type shown in figures 2 and 5 are configured such that they have no option but to use the DP2 pipeline for processing volumetric point filtering results, when those point filtering results are to be used in further filtering methods. Thus, the present disclosure provides for a modified texture filtering unit that is configured to directly store the input texture value for a volumetric point filtering (when anisotropic and/or trilinear filtering operations are also engaged) into a register, instead of using the DP2 pipeline of the datapath block to store the input texture value. This advantageously avoids using up the DP2 for a cycle in an operation that would not change the value of the input texture value for volumetric point filtering. This advantage can also be obtained in standard (non-point) volumetric filtering, though with less frequency, as described below.

The signals used to indicate a volumetric point filtering may be **vol_en** = 1 and **vfrac** = 0. In other words, volumetric filtering is enabled, and the coefficient is set to zero (though in some examples there may also be another, dedicated, signal value to indicate volumetric point filtering thus to differentiate it from standard, non-point, volumetric filtering). If this condition exists in a given cycle, then the presently modified texture filtering unit is configured to directly send the selected a0 sample input to the scratchpad register bank, bypassing the DP2 pipeline. Preferably, the a0 sample input is sent to the same location that the interpolation result would otherwise be sent to according to the scheduling logic. This location can therefore be determined by identifying which register the DP2 pipeline would have been configured to use to store the intermediate result of the filtering. This identification can be performed by determining which register the control block 208 would have determined to use as the output for the next interpolation operation by the DP2.

This modification yields the result that, instead of wasting multiple cycles inputting the a0 and a1 bilinear outputs to the DP2 and utilising the DP2 to perform an unnecessary interpolation, only one cycle is used to write a value directly to a register bank, where that value may be used immediately in the next cycle as an input to the DP2 for a useful filtering operation. The advantage of this modification is that the DP2 is available during the cycle in which the a0 value is written to the register bank 220. Moreover, power consumption is reduced since one DP2 operation is avoided. Consequently, the DP2 is available to be scheduled and used by another sequencer that does need to use the DP2 functionality during the cycle in which the volumetric point filtering texture value bypasses the DP2 to be stored in a register. This significantly improves overall performance, since at least two cycles may be saved in some examples. This improvement can safely be made because the DP2 operation that is skipped (i.e., the interpolation with a coefficient of 0) would not have resulted in the final output. Furthermore, because volumetric point filtering workloads are non-negligible in typical rasterisation workloads that are likely to occur in a series of filtering sequences, the small amount of additional logic/hardware (not shown in figures 2 and 5) used to implement the control logic is justified by the improvement in performance.

Furthermore, no additional registers are needed (in some examples, each set of scratchpad registers 220 comprises 5 registers) to provide this solution. The only additional logic required is logic to connect the inputs with the scratchpad register. In known examples of the texture filtering units, e.g., as shown in figure 5, the scratchpad registers are configured to operate in one of three ways per cycle: i) register an 'ADD' pipeline 219 output, ii) register a DP2 pipeline 218 output, or iii) do not update scratchpad registers. The signals used to indicate which of these operations to perform are determined from the values of the last sideband register store_add or store_dp2, as shown in the datapath 210 of figure 5. In other words, currently, the only way to store a new value in a scratchpad register is via one of the pipelines 218, 219. The present improvement to the 3D point filtering described above can be implemented simply by adding logic to directly connect the inputs with the scratchpad register, bypassing the pipelines 218, 219.

Although not indicated in figure 5 (merely for illustrative clarity), there are at least two ways that the logic of the texture filter unit 500 could be modified to effect the filter unit improvement disclosed herein. A first option is to use the input a0 (204) as an additional input to the store muxes 222, so that the a0 value can be passed directly into a scratchpad register 200. This means that the a0 value does not need to be registered in a0_r, which is advantageous because this saves power relative to known implementations. Due to the fact that a0 is an input, it may be that the timing constraints required are more stringent: for example, a slight delay may be caused if there is a long logical path leading up to the a0 input 204, or if there are long wires beforehand. This option is therefore potentially dependent on the previous hardware in the particular implementation. A second option is to use the registered version of a0 input 204, which is indicated as register A0_R (504) in figure 5. The output of this register 504 (which in figure 5 only outputs values to the SRC muxes 223) may be used as additional input to the store muxes 222. This second option may be beneficial if the preceding hardware makes the first option less feasible. In known implementations, a0 is already registered to A0_R, so there should be negligible (or no) additional power consumption relative to known methods in order to operate the additional logic of this second option.

As mentioned, volumetric filtering is signalled to the texture filtering unit using the **vol_en** = 1. When vfrac is set to equal 0, this can also indicate that specifically volumetric point filtering is in operation. Alternatively, another dedicated signal (not shown in figures) could be used to indicate that volumetric point filtering is to be performed. In some examples, the coefficients, including vfrac, a fixed point number format of 8 bits, i.e., representing the values 0 to 255. Consequently, when standard (i.e., non-point) volumetric filtering is being performed, there is a small probability (i.e., a 1 in 256 chance) that the coefficient, vfrac, will equal zero. In practice, the probability may be even higher, even when the fixed point value comprises 8 bits. For example, the fractional part of a particular filtering mode may be lower than the 8 bits allocated to vfrac. Thus, in a specific example, only 4 bits of the possible 8 fractional bits may actually be used to represent the vfrac values (the remaining 4 bits always being zero), meaning that the probability of the vfrac value being 0 overall is 1/16.

When only volumetric filtering is enabled (and no other filtering operation), due to the logic of known implementations, the texture filtering unit needs to schedule a DP2 interpolation in order to get the value from a0 to the output, irrespective of the coefficient value. Consequently, the DP2 pipeline normally has to calculate an interpolation based on a coefficient of zero, which doesn't affect the result of a0. This effectively wastes the resource of the DP2 for one cycle when only volumetric filtering is performed and when the vfrac, by chance, equals zero. Therefore, in some implementations, the texture filtering unit may be configured to bypass the DP2 in all cases in which **vol_en** = 1 and **vfrac** = 0, even in the case of sporadic appearances of **vfrac** = 0 when the only filter operation being performed is standard volumetric filtering. This would, however, only yield small additional benefits (i.e., in addition to the benefit of bypassing the DP2 for point filtering operations) due to the unlikely (1 in 256 chance, or higher) probability of vfrac = 0 occurring during standard volumetric filtering. Furthermore, since implementing a DP2 bypass for this generic case where **vol_en** = 1 and **vfrac** = 0 would require more additional logic (in addition to the logic to bypass the DP2 for point filtering operations), it is preferable in some cases only to implement the DP2 bypass when (either point or non-point) volumetric filtering is enabled and when at least one of anisotropic filtering and/or trilinear filtering is also used.

Consequently, in one example modified texture filtering unit, the hardware is configured to bypass the DP2 and store the 3D point filtering output in directly in the scratchpad register only when **vol_en** = 1 and **vfrac** = 0, AND when **ani_rt** > 0 OR **tri_en** = 1. Advantageously, this means that the texture filtering unit is agnostic to the specific sub-type of volumetric filtering, i.e., whether point filtering or non-point filtering is being used. Instead, the texture filtering unit is configured always to bypass the DP2 whenever **vol_en** = 1 and **vfrac** = 0; AND **ani_rt** > 0 OR **tri_en** = 1 occurs, by skipping the interpolation and directly writing the texture input (which, since it needs no processing, represents an intermediate output value) to a register. The possible modes of operation are therefore summarised in the following table:

| Signals | Filtering mode | Operation |
|---|---|---|
| **vol_en** = 1<br>**vfrac** = 0<br>**ani_rt** = 0<br>**tri_en** = 0 | Only volumetric point filtering. | The input texture value will not pass through the texture filtering unit at all, and but will bypass it entirely. In other words, the texture filtering unit is unused, and instead a parallel path is used in the surrounding hardware in, or outside of, the texture filtering unit.<br>This uses unmodified logic of the texture filtering unit (e.g., shown in figure 2 or 5). |
| **vol_en** = 1<br>**vfrac** = 0<br><br>**ani_rt** = 0<br>**tri_en** = 0 | Only standard (non-point) volumetric filter-ing.<br>vfrac is zero by chance. | The DP2 pipeline is scheduled to interpolate a0 and a1, with a coefficient of zero, in order to pass a0 through to the output. The value of a1 may be set of equal '-0'.<br><br>This uses unmodified logic of the texture filtering unit (e.g., shown in figure 2 or 5). |
| **vol_en** = 1<br>**vfrac** = 0<br>AND<br>**ani_rt** > 0<br>OR<br>**tri_en** = 1 | Point filtering is used in combination with one or more of anisotropic fil-tering and trilinear fil-tering | The input, a0, is directly registered in a scratchpad register, bypassing the DP2 pipeline.<br>This uses the modified logic in presently described embodiments of the texture filtering unit (not shown in figure 2 or 5). |
| **vol_en** = 1<br>**vfrac** = 0<br>AND<br>**ani_rt** > 0<br>OR<br>**tri_en** = 1 | Standard (non-point) volumetric filtering is used in combination with one or more of anisotropic filtering and trilinear filtering.<br>vfrac is zero by chance. | The input, a0, is directly registered in a scratchpad register, bypassing the DP2 pipeline.<br>This uses the modified logic in presently described embodiments of the texture filtering unit (not shown in figure 2 or 5). |

It should therefore be appreciated that the texture filtering unit operates in the same way for both filtering modes in rows 3 and 4 of the table above, irrespective of whether point filtering has been explicitly signalled or not. Thus, the advantage of the logic explained in the table above is that the texture filtering unit is agnostic to whether point or non-point volumetric filtering is being used, provided that volumetric filtering is being used in a filtering mode that is combined with one or both of anisotropic filtering and trilinear filtering (or some other filtering method that also uses the DP2 pipeline). Indeed, in some implementations, the filtering unit is not configured to distinguish between volumetric point filtering from non-point volumetric filtering. This information is, however, available to the immediately surrounding hardware which drives the texture filtering unit. Thus, in some examples, an additional interface signal is included which communicates this information (i.e., whether non-point or point volumetric filtering is being used) to the texture filtering unit.

It should be appreciated that the improvement in efficiency will be significantly more frequently achieved for the third row than for the fourth row, i.e., when point filtering is combined with another filtering method, and will be achieved with uniform probability. This is because point filtering represents a non-negligible proportion of typical filtering workloads, whereas the standard (non-point) filtering method will only yield vfrac = 0 at random. The improvement in efficiency is therefore significant, and constant, when volumetric point filtering is combined with another filtering mode. In a specific example, in previous implementations filtering mode combining 3D point filtering and trilinear filtering would use the DP2 pipeline three times previously. In the modified configuration, the DP2 pipeline is used once, i.e., because the DP2 does not need to be used at all for the point filtering interpolation, and thus may be used exactly once to calculate an interpolation used for the trilinear filter operation. It can therefore be seen that the pipeline is freed for as many as two cycles, the DP2 is thus available for use by other sequencers during those now-free cycles.

Nevertheless, the modified logic of the present texture filtering unit can be utilised by the fourth row mode (standard (non-point) filtering method combined with another filtering method) without any additional logic or scheduling overhead. A small improvement in efficiency will still be achieved, over time, with a constant probability distribution. The improvement in efficiency will therefore be consistently and predictably achieved over time.

In the case where the filtering mode comprises only standard (non-point) volumetric filtering, vfrac may be zero by chance (e.g., 1 in 256 vfrac values may be zero for an 8-bit fixed point value). Generally, when only volumetric filtering is used in a filtering mode, the result of the interpolation need not be stored as an intermediate value in a register and may be passed straight to the output. Current implementations of the texture filtering unit are configured to pass a value to output only via the datapath pipelines. Consequently, even when vfrac = 0, there is no mechanism to bypass the DP2. Thus, the DP2 is used to pass the input texture value (a0) to the output by performing an interpolation with the coefficient value set to zero. Furthermore, in order to ensure that the sign of the output is unchanged, the redundant interpolant, a1, is set to '-0'. This is because the IEEE 754 standard rules of floating point arithmetic dictate that (-0) + (-0) = -0. If one of the terms in an addition is +0 and the other +/-0, the result is +0. For volumetric point filtering, the objective is to use the value in a0 directly for the next filtering step without a1 influencing the result. Thus, when interpolating with vfrac = 0, the sign of a1 is set to be negative in order to avoid the scenario in which a0 happens to be -0 and a1 happens to be positive. More generally, in order to achieve the same objective of not influencing the sign of the output if a0 happens to equal -0, a1 may be set to be any negative value other than 'infinity' or 'NaN'.

Determining whether the interpolation can be skipped and the DP2 bypassed, dependent on the signals, may be performed by the main controller 502, or in some examples one of the sequencers (because the sequencers have access to data that defines the cycle, i.e., the sequencers 'know' when the cycle is a volumetric input cycle). The arbiter 214 is configured to allocate the freed-up DP2, during the cycle in which it is bypassed, and the input value (a0) is stored directly in a scratchpad register, to another sequencer. In more detail, in conjunction with the arbiter allocating the freed-up DP2, a sequencer of the plurality of sequencers is configured, during the cycle in which the DP2 is bypassed, to schedule/instruct a DP2 pipeline to perform a different computation using two intermediate texture values stored in a scratchpad register. The scheduling causes the DP2 to perform the computation in a following cycle, i.e., the immediately following cycle. Without the improvement of the modified texture filtering unit, the skipped DP2 operation (i.e., relating to the input value that bypasses the DP2) would have been scheduled on the DP2 instead, and the different computation (using two intermediate texture values stored in a scratchpad register) would have had to wait until the next (or even later) cycle to even be scheduled.

Further advantageously, the logic of the sequencer can stay mostly the same with only a minor modification. The minor modification relates to a structure of the final state machine (FSM) defining the sequencer (and defining the conditions for state transitions and the like). The modification represents an extra condition used to check whether the conditions that would enable the DP2 to be 'skipped' are present. In detail, these conditions are that: i) the sequencer is in a state where it needs to process an input cycle for a volumetric filtering sequence (provided it is not a point-volumetric-filtering-only sequence as in the first row of the table above), and ii) the vfrac value is 0.

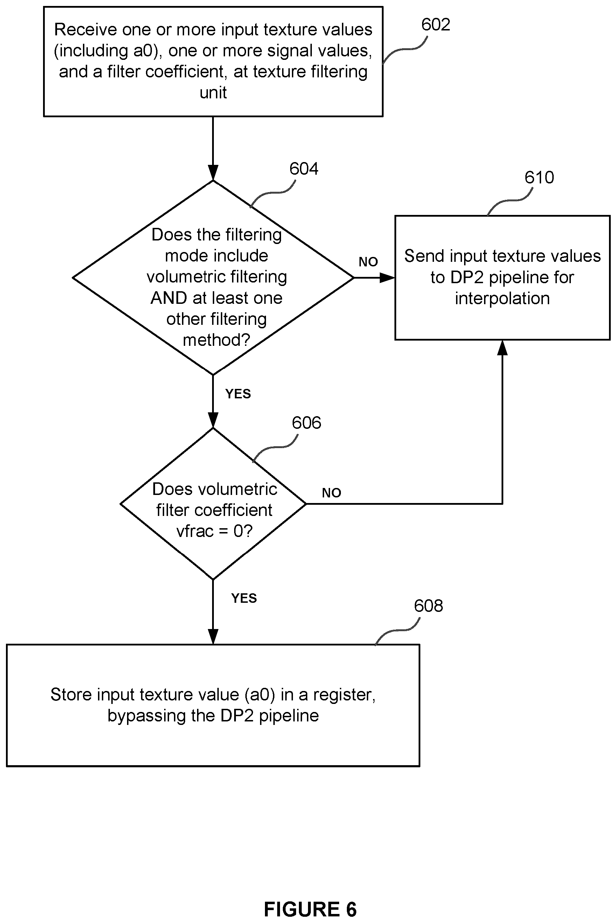

Figure 6 shows a flowchart illustrating an example operation of the texture filtering unit during a filtering mode in which volumetric filtering is combined with at least one other filtering method, and where vfrac = 0. The operations of figure 6 only illustrate the operations that follow from receiving texture values over one cycle. Operations of subsequent cycles (in which more texture values will be received) are not shown. The operation of the flowchart encompasses both the scenario in which volumetric point filtering is combined with another filtering method, and the case in which standard (non-point) volumetric filtering is combined with another filtering method but where vfrac = 0 by chance.

At step 602, one or more input texture values (including a0), one or more signal values, and a filter coefficient, are received at the texture filtering unit. In some cases, only one texture value (a0) may be received. In other examples, two values (a0, and a1) may be received. The signals may comprise the signals, vol_en, ani_rt, and tri_en.

At step 604 it is determined whether the filtering mode (which is defined at least by the one or more signal values) includes volumetric filtering, and also includes at least one other filtering method (i.e., one or both of anisotropic filtering and trilinear filtering). This may correspond to determining whether **vol_en** = 1, and whether at least one of **ani_rt** > 0 and **tri_en** = 1 is true. If these conditions are determined and step 604 is determined positively, the process moved to step 606. At step 606, it is determined whether the volumetric filter coefficient, vfrac, is equal to zero. If so, the process stores the input texture value (a0) in a register, thus bypassing the DP2 pipeline. Consequently, the method does not need to explicitly determine whether point or non-point volumetric filtering is being performed, i.e., the texture filtering unit is agnostic to this. However, if point filtering is being used, only a0 may be received at the texture filtering unit (and vfrac may have been intentionally set to equal zero), whereas if standard (non-point) filtering is used then two texture inputs may be received as normal (a0 and a1) and vfrac equals zero by chance.

It is presumed, for the sake of explanation, that the filtering mode defined by the one or more signals received in step 602 includes at least volumetric filtering. Thus, if it is determined at step 604 that another filtering method is not used in addition to volumetric filtering, it can thereby be determined that the only filtering method being used is standard (non-point) volumetric filtering. If only volumetric point filtering were being used, as explained in the first row of the table above, the texture filtering unit would be bypassed entirely since texel value can be immediately sent to an output. This is not the case for standard volumetric filtering, however. Thus, if step 604 is determined negatively, this corresponds to the case where standard (non-point) volumetric filtering is being used. It is therefore immaterial whether vfrac is zero or not, since the only logic available to the texture filtering unit in this scenario is to use the DP2 pipeline (i.e., as explained in the second row of the table above). Consequently, the texture input values are sent to the DP2. If vfrac is zero, then an interpolation with zero is performed and the DP2 stores the result, which will be a0, in a register. Otherwise, a standard interpolation is performed between the values of a0 and a1, using the coefficient vfrac.

If step 606 is determined negatively, this corresponds to a case in which standard (non-point) volumetric filtering is used in combination with at least one other filtering mode. In this case, the texture input values, a0 and a1, will be sent to the DP2 pipeline for interpolation in the standard way, using coefficient vfrac. The intermediate output value generated by the DP2 pipeline will subsequently be stored in a register.

The examples described in detail herein generally relate to a texture filtering unit configured to perform a texture filtering process. However, it is to be understood that the texture filtering unit is an example of a filtering unit, and the texture filtering process is an example of a filtering process, and in other examples the same principles described herein in the context of texture filtering can be applied to other types of filtering. For example, the techniques described herein could be applied for image filtering, e.g. for purposes such as blurring, sharpening and noise reduction, and the like. Image filtering often involves applying a weighted sum to a set of pixel values (e.g. colour values), which is very similar to the anisotropic mode described above in relation to texture filtering, although with different weights. Another example of image filtering in which the techniques described herein could be applied is in a convolution kernel, for example as part of a convolutional neural network. This again involves a weighted average that is applied to pixel values (e.g. colour values), but this time as part of a neural network. The techniques described herein could also be applied to 'non-image' filtering, e.g. any other linear filtering (i.e. filtering that can be represented as a weighted sum). For example, a Fast Fourier Transform (FFT) falls under this category, which is useful for many applications where a (usually) time series such as from an audio signal can be transformed into a frequency representation, and the techniques described herein can be used in these examples too.

Furthermore, although the specific examples described in detail herein relate to implementing texture filtering within a rasterisation system, the same texture filtering techniques could be implemented in other rendering systems, e.g. in a ray tracing system. For example, in a ray tracing system, when a ray has been found to intersect a primitive at an intersection point then a texture can be sampled and filtered as described herein in order to determine a colour value for the intersection.

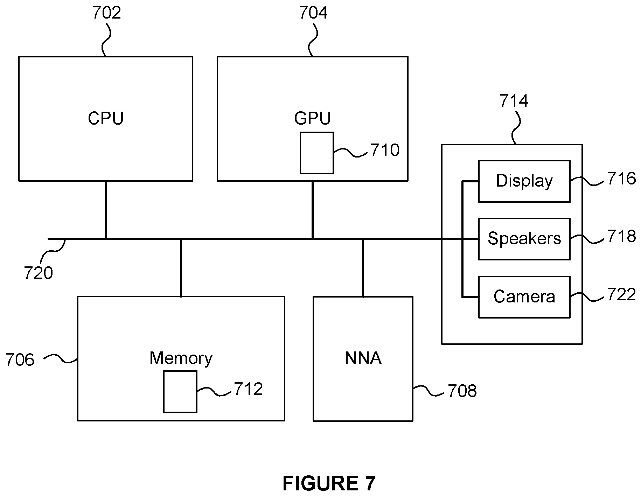

Figure 7 shows a computer system in which the graphics processing systems described herein may be implemented. The computer system comprises a CPU 702, a GPU 704, a memory 706, a neural network accelerator (NNA) 708 and other devices 714, such as a display 716, speakers 718 and a camera 722. A processing block 710 (which may comprise the rendering logic 100 and/or the texture filtering unit 102) is implemented on the GPU 704. In other examples, one or more of the depicted components may be omitted from the system, and/or the processing block 710 may be implemented on the CPU 702 or within the NNA 708. The components of the computer system can communicate with each other via a communications bus 720. A store 712 (which may correspond to memory 105) is implemented as part of the memory 706.

The filtering units described herein (which in some examples are texture filtering units) are shown as comprising a number of functional blocks. This is schematic only and is not intended to define a strict division between different logic elements of such entities. Each functional block may be provided in any suitable manner. It is to be understood that intermediate values described herein as being formed by a filtering unit need not be physically generated by the filtering unit at any point and may merely represent logical values which conveniently describe the processing performed by the filtering unit between its input and output.

The filtering units described herein may be embodied in hardware on an integrated circuit. The filtering units described herein may be configured to perform any of the methods described herein. Generally, any of the functions, methods, techniques or components described above can be implemented in software, firmware, hardware (e.g., fixed logic circuitry), or any combination thereof. The terms "module," "functionality," "component", "element", "unit", "block" and "logic" may be used herein to generally represent software, firmware, hardware, or any combination thereof. In the case of a software implementation, the module, functionality, component, element, unit, block or logic represents program code that performs the specified tasks when executed on a processor. The algorithms and methods described herein could be performed by one or more processors executing code that causes the processor(s) to perform the algorithms/methods. Examples of a computer-readable storage medium include a random-access memory (RAM), read-only memory (ROM), an optical disc, flash memory, hard disk memory, and other memory devices that may use magnetic, optical, and other techniques to store instructions or other data and that can be accessed by a machine.

The terms computer program code and computer readable instructions as used herein refer to any kind of executable code for processors, including code expressed in a machine language, an interpreted language or a scripting language. Executable code includes binary code, machine code, bytecode, code defining an integrated circuit (such as a hardware description language or netlist), and code expressed in a programming language code such as C, Java or OpenCL. Executable code may be, for example, any kind of software, firmware, script, module or library which, when suitably executed, processed, interpreted, compiled, executed at a virtual machine or other software environment, cause a processor of the computer system at which the executable code is supported to perform the tasks specified by the code.

A processor, computer, or computer system may be any kind of device, machine or dedicated circuit, or collection or portion thereof, with processing capability such that it can execute instructions. A processor may be or comprise any kind of general purpose or dedicated processor, such as a CPU, GPU, NNA, System-on-chip, state machine, media processor, an application-specific integrated circuit (ASIC), a programmable logic array, a field-programmable gate array (FPGA), or the like. A computer or computer system may comprise one or more processors.

It is also intended to encompass software which defines a configuration of hardware as described herein, such as HDL (hardware description language) software, as is used for designing integrated circuits, or for configuring programmable chips, to carry out desired functions. That is, there may be provided a computer readable storage medium having encoded thereon computer readable program code in the form of an integrated circuit definition dataset that when processed (i.e. run) in an integrated circuit manufacturing system configures the system to manufacture a filtering unit configured to perform any of the methods described herein, or to manufacture a filtering unit comprising any apparatus described herein. An integrated circuit definition dataset may be, for example, an integrated circuit description.

Therefore, there may be provided a method of manufacturing, at an integrated circuit manufacturing system, a filtering unit as described herein. Furthermore, there may be provided an integrated circuit definition dataset that, when processed in an integrated circuit manufacturing system, causes the method of manufacturing a filtering unit to be performed.

An integrated circuit definition dataset may be in the form of computer code, for example as a netlist, code for configuring a programmable chip, as a hardware description language defining hardware suitable for manufacture in an integrated circuit at any level, including as register transfer level (RTL) code, as high-level circuit representations such as Verilog or VHDL, and as low-level circuit representations such as OASIS (RTM) and GDSII. Higher level representations which logically define hardware suitable for manufacture in an integrated circuit (such as RTL) may be processed at a computer system configured for generating a manufacturing definition of an integrated circuit in the context of a software environment comprising definitions of circuit elements and rules for combining those elements in order to generate the manufacturing definition of an integrated circuit so defined by the representation. As is typically the case with software executing at a computer system so as to define a machine, one or more intermediate user steps (e.g. providing commands, variables etc.) may be required in order for a computer system configured for generating a manufacturing definition of an integrated circuit to execute code defining an integrated circuit so as to generate the manufacturing definition of that integrated circuit.

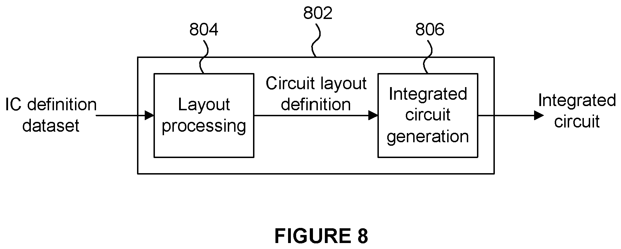

An example of processing an integrated circuit definition dataset at an integrated circuit manufacturing system so as to configure the system to manufacture a filtering unit will now be described with respect to Figure 8.

Figure 8 shows an example of an integrated circuit (IC) manufacturing system 802 which is configured to manufacture a filtering unit as described in any of the examples herein. In particular, the IC manufacturing system 802 comprises a layout processing system 804 and an integrated circuit generation system 806. The IC manufacturing system 802 is configured to receive an IC definition dataset (e.g. defining a filtering unit as described in any of the examples herein), process the IC definition dataset, and generate an IC according to the IC definition dataset (e.g. which embodies a filtering unit as described in any of the examples herein). The processing of the IC definition dataset configures the IC manufacturing system 802 to manufacture an integrated circuit embodying a filtering unit as described in any of the examples herein.

The layout processing system 804 is configured to receive and process the IC definition dataset to determine a circuit layout. Methods of determining a circuit layout from an IC definition dataset are known in the art, and for example may involve synthesising RTL code to determine a gate level representation of a circuit to be generated, e.g. in terms of logical components (e.g. NAND, NOR, AND, OR, MUX and FLIP-FLOP components). A circuit layout can be determined from the gate level representation of the circuit by determining positional information for the logical components. This may be done automatically or with user involvement in order to optimise the circuit layout. When the layout processing system 804 has determined the circuit layout it may output a circuit layout definition to the IC generation system 806. A circuit layout definition may be, for example, a circuit layout description.

The IC generation system 806 generates an IC according to the circuit layout definition, as is known in the art. For example, the IC generation system 806 may implement a semiconductor device fabrication process to generate the IC, which may involve a multiple-step sequence of photo lithographic and chemical processing steps during which electronic circuits are gradually created on a wafer made of semiconducting material. The circuit layout definition may be in the form of a mask which can be used in a lithographic process for generating an IC according to the circuit definition. Alternatively, the circuit layout definition provided to the IC generation system 806 may be in the form of computer-readable code which the IC generation system 806 can use to form a suitable mask for use in generating an IC.

The different processes performed by the IC manufacturing system 802 may be implemented all in one location, e.g. by one party. Alternatively, the IC manufacturing system 802 may be a distributed system such that some of the processes may be performed at different locations, and may be performed by different parties. For example, some of the stages of: (i) synthesising RTL code representing the IC definition dataset to form a gate level representation of a circuit to be generated, (ii) generating a circuit layout based on the gate level representation, (iii) forming a mask in accordance with the circuit layout, and (iv) fabricating an integrated circuit using the mask, may be performed in different locations and/or by different parties.

In other examples, processing of the integrated circuit definition dataset at an integrated circuit manufacturing system may configure the system to manufacture a filtering unit without the IC definition dataset being processed so as to determine a circuit layout. For instance, an integrated circuit definition dataset may define the configuration of a reconfigurable processor, such as an FPGA, and the processing of that dataset may configure an IC manufacturing system to generate a reconfigurable processor having that defined configuration (e.g. by loading configuration data to the FPGA).

In some embodiments, an integrated circuit manufacturing definition dataset, when processed in an integrated circuit manufacturing system, may cause an integrated circuit manufacturing system to generate a device as described herein. For example, the configuration of an integrated circuit manufacturing system in the manner described above with respect to Figure 8 by an integrated circuit manufacturing definition dataset may cause a device as described herein to be manufactured.

In some examples, an integrated circuit definition dataset could include software which runs on hardware defined at the dataset or in combination with hardware defined at the dataset. In the example shown in Figure 8, the IC generation system may further be configured by an integrated circuit definition dataset to, on manufacturing an integrated circuit, load firmware onto that integrated circuit in accordance with program code defined at the integrated circuit definition dataset or otherwise provide program code with the integrated circuit for use with the integrated circuit.

The implementation of concepts set forth in this application in devices, apparatus, modules, and/or systems (as well as in methods implemented herein) may give rise to performance improvements when compared with known implementations. The performance improvements may include one or more of increased computational performance, reduced latency, increased throughput, and/or reduced power consumption. During manufacture of such devices, apparatus, modules, and systems (e.g. in integrated circuits) performance improvements can be traded-off against the physical implementation, thereby improving the method of manufacture. For example, a performance improvement may be traded against layout area, thereby matching the performance of a known implementation but using less silicon. This may be done, for example, by reusing functional blocks in a serialised fashion or sharing functional blocks between elements of the devices, apparatus, modules and/or systems. Conversely, concepts set forth in this application that give rise to improvements in the physical implementation of the devices, apparatus, modules, and systems (such as reduced silicon area) may be traded for improved performance. This may be done, for example, by manufacturing multiple instances of a module within a predefined area budget.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein. In view of the foregoing description it will be evident to a person skilled in the art that various modifications may be made within the scope of the invention.

**Claims**

1. A filtering unit implemented in hardware logic, the filtering unit configured to apply one or more filtering methods to a plurality of input values to determine output values, the filtering unit comprising:

   a plurality of inputs configured to receive: one or more input values, one or more signal values, one or more filter coefficients, wherein the one or more signal values define a filtering mode and wherein each of the one or more filter coefficients corresponds to one of the one or more filtering methods;
   a computation pipeline, wherein the computation pipeline is configured to:

   receive two input values and a corresponding filter coefficient; and
   perform an interpolation using at least the two input values and the corresponding filter coefficient;

a plurality of registers configured to store intermediate output values generated by the computation pipeline;

wherein the filtering unit is configured to:

receive one or more signal values, a volumetric filter coefficient, and an input value;
determine i) that a filtering mode defined by the received one or more signal values comprises volumetric filtering and at least one other filtering method and ii) that the volumetric filter coefficient is equal to zero;
in response to determining i) and ii), store the received input value in a register of the plurality of registers.

2. The filtering unit of claim 1, wherein the filtering unit is configured to store the received input value in a register, in response to determining i) and ii), by bypassing the computation pipeline thereby without causing the computation pipeline to perform an interpolation using the received input value.

3. The filtering unit of claim 1 or 2, wherein the filtering unit is configured to determine which register to use to store the received input value in response to identifying which register the computation pipeline would have been configured to use to store a result of an interpolation using the input value and the volumetric filter coefficient.

4. The filtering unit of any preceding claim, wherein the volumetric filtering method defined by the received one or more signal values is a volumetric point filtering method.

5. The filtering unit of any preceding claim, wherein the computation pipeline is configured to perform a 2-dimensional dot product, and wherein the computation pipeline is configured to perform the interpolation between the two input values, $a0$ and $a1$, and the corresponding filter coefficient, $c$, by calculating $(a0 * (1 - c)) + (a1 * c)$, wherein the input value received by the filtering unit corresponds to $a0$.

6. The filtering unit of any preceding claim, wherein the filtering unit is configured to use the input value, stored in the register, for input into the computation pipeline in a subsequent cycle in combination with a further input value.

7. The filtering unit of any preceding claim, wherein the filtering unit is configured to receive one or two input values per cycle, and is configured to perform one computation using the computation pipeline per cycle.

8. The filtering unit of any preceding claim, wherein the filtering unit comprises a plurality of sequencers, wherein each sequencer is configured, in dependence on one or more received control inputs, to instruct the computation pipeline to perform a computation using two input values.

9. The filtering unit of claim 8, wherein one sequencer of the plurality of sequencers is configured, during a cycle in which the received input value is stored in the register in response to determining i) and ii), to instruct the computation pipeline to perform a computation using two intermediate output values stored in the plurality of registers, wherein each sequencer comprises a plurality of hard-coded micro-programs and hardware logic arranged to select one of the micro-programs based on the one or more control inputs, wherein each micro-program defines a sequence of operations to be performed by computation pipeline as part of a filtering operation.

10. The filtering unit of claim 8 or 9, wherein the filtering unit comprises a control block, wherein the plurality of sequencers is disposed within the control block, and wherein the control block is configured to output, for each intermediate output value generated by the computation pipeline, a destination for the intermediate output value.

11. The filtering unit of any preceding claim, wherein the one or more filtering methods includes anisotropic filtering, trilinear filtering, and volumetric filtering, and wherein the filtering unit is configured to perform any combination of the one or more filtering methods, wherein the filtering unit is configured to perform any combination of one or more filtering method using the priority order of i) volumetric filtering, ii) anisotropic filtering, and iii) trilinear filtering.

12. The filtering unit of any preceding claim, wherein the computation pipeline is further configured to perform an addition between two received input values.

13. The filtering unit of any preceding claim, wherein the filtering unit is comprised as part of a graphics processing unit, and wherein the filtering unit is a texture filtering unit, and wherein the one or more filtering methods are one or more texture filtering methods.

**14.** A method of applying one or more filtering methods to a plurality of input values to determine output values within a filtering unit, wherein the filtering unit comprises a plurality of inputs, a plurality of registers, and a computation pipeline configured to perform an interpolation using at least two input values and a corresponding filter coefficient, the method comprising:

receiving, at the plurality of inputs of the filtering unit:

one or more signal values defining a filtering mode;
a volumetric filter coefficient, corresponding to a volumetric filtering method;
an input value;

determining, at the filtering unit, i) that the filtering mode defined by the one or more signal values comprises volumetric filtering and at least one other filtering method and ii) that the volumetric filter coefficient is equal to zero;
in response to determining i) and ii), storing the received input value in a register of the plurality of registers, wherein the plurality of registers is configured to store intermediate output values generated by the at least one computation pipeline.

**15.** An integrated circuit definition dataset that, when processed in an integrated circuit manufacturing system, configures the integrated circuit manufacturing system to manufacture a filtering unit as claimed in any of claims 1 to 13.

Geometry

**Geometry Processing Logic** — 104

Vertex Shader — 108

Tessellation Unit — 110

Memory — 105

**Fragment processing Logic** — 106

Bilinear interpolation unit — 107

Texture Filtering Unit — 102

Pixel Shader — 112

Image

100

**FIGURE 1**

**FIGURE 2**

**FIGURE 3**

**FIGURE 4**

FIGURE 5

Receive one or more input texture values
(including a0), one or more signal values,
and a filter coefficient, at texture filtering
unit

602

Does the filtering
mode include
volumetric filtering
AND at least one
other filtering
method?

604

NO

Send input texture values
to DP2 pipeline for
interpolation

610

YES

Does volumetric
filter coefficient
vfrac = 0?

606

NO

YES

Store input texture value (a0) in a register,
bypassing the DP2 pipeline

608

**FIGURE 6**

**FIGURE 7**

FIGURE 8

EP 4 654 139 A1

# EUROPEAN SEARCH REPORT

**Application Number**

EP 25 17 7749

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2019/311520 A1 (VAN BENTHEM CASPER [GB]) 10 October 2019 (2019-10-10) * paragraph [0036] - paragraph [0043]; figures 1, 2, 3A, 4 * | 1-15 | INV. G06T15/00 G06T15/04 |
| | | | **TECHNICAL FIELDS SEARCHED (IPC)** |
| | | | G06T |

The present search report has been drawn up for all claims

| Place of search | Date of completion of the search | Examiner |
|---|---|---|
| The Hague | 18 July 2025 | Martos Riaño, Demian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 17 7749

This annex lists the patent family members relating to the patent documents cited in the above-mentioned European search report.
The members are as contained in the European Patent Office EDP file on
The European Patent Office is in no way liable for these particulars which are merely given for the purpose of information.

18-07-2025

| Patent document cited in search report | | Publication date | Patent family member(s) | | Publication date |
|---|---|---|---|---|---|
| US 2019311520 | A1 | 10-10-2019 | CN | 110349244 A | 18-10-2019 |
| | | | CN | 115393493 A | 25-11-2022 |
| | | | EP | 3591619 A1 | 08-01-2020 |
| | | | EP | 4191535 A1 | 07-06-2023 |
| | | | GB | 2567507 A | 17-04-2019 |
| | | | GB | 2577619 A | 01-04-2020 |
| | | | US | 2019311520 A1 | 10-10-2019 |
| | | | US | 2020193680 A1 | 18-06-2020 |
| | | | US | 2022084276 A1 | 17-03-2022 |

EPO FORM P0459

For more details about this annex : see Official Journal of the European Patent Office, No. 12/82

**REFERENCES CITED IN THE DESCRIPTION**

**Patent documents cited in the description**

- GB 2407299 A